# EUROPÄISCHE PATENTSCHRIFT

(11) **EP 2 389 541 B1**
(45) Veröffentlichungstag und Bekanntmachung des Hinweises auf die Patenterteilung: **19.07.2017**
(21) Anmeldenummer: 10700247.9
(22) Anmeldetag: 13.01.2010
(51) Int. Cl.: F24C 7/08, G05G 1/08, H03K 17/97

(54) **BEDIENVORRICHTUNG EINES HAUSHALTSGERÄTS**
CONTROL DEVICE FOR A DOMESTIC APPLIANCE
DISPOSITIF DE COMMANDE D'UN APPAREIL ÉLECTROMÉNAGER

(30) Priorität: 23.01.2009 DE 102009000387
(43) Veröffentlichungstag der Anmeldung: 30.11.2011
(73) Patentinhaber: BSH Hausgeräte GmbH, 81739 München (DE)
(72) Erfinder: HUBER, Johann, 83334 Inzell (DE); MARBACH, Andreas, 83374 Traunwalchen (DE); SCHUHBAECK, Peter, 83329 Holzhausen (DE); WURNITSCH, Ernst, A-6382 Kirchdorf in Tirol (AT); HACKBARTH, Andreas, 81479 München (DE); WILSDORF, Gerd, 82140 Olching (DE)
(86) Internationale Anmeldenummer: PCT/EP2010/050312
(87) Internationale Veröffentlichungsnummer: WO 2010/084061

(56) Entgegenhaltungen:
- EP-A2- 1 167 109
- WO-A1-2004/038298
- DE-A1-102006 045 735
- DE-U1-202004 017 133
- US-A- 3 711 672

## Beschreibung

Die Erfindung geht aus von einer Bedienvorrichtung nach dem Oberbegriff des Anspruchs 1.

Aus der DE 10 2006 045 735 A1 ist eine Kochfeldbedienvorrichtung eines Haushaltsgeräts mit einer Bedienmittelträgereinheit bekannt, die ein Funktionsfeld aufweist, das zur Kopplung mit einem abnehmbaren Bedienmittel vorgesehen ist. Die Bedienmittelträgereinheit kann dabei von einer Glaskeramikplatte oder einer Blende gebildet sein. Das Bedienmittel ist zur Realisierung einer von einer Drehbewegung abweichenden Bedienfunktion formveränderlich, und zwar zusammendrückbar, ausgebildet. Ferner ist aus der DE 10 2006 045 735 A1 bekannt, Rastmagnete vorzusehen, um eine magnetische Rastung als haptische Rückmeldung an eine Bedienperson zu erzeugen.

Aus der DE 20 2005 019 978 U1 ist ein Bedienmittel bekannt, das einen Metallstern aufweist, der mit einem Magneten verbunden ist, so dass einzelne Arme des Metallsterns ebenfalls magnetisch sind. Mit unter einer Glaskeramikplatte angeordneten Hall-Sensoren kann mittels des Metallsterns eine Drehstellung ermittelt werden.

Weiterer relevanter Stand der Technik ist in den Dokumenten DE 20 2004 017 133 U1 und US 3 711 672 zu finden. Die Aufgabe der Erfindung besteht insbesondere darin, eine gattungsgemäße Vorrichtung mit verbesserten Eigenschaften hinsichtlich einer Signalauswertemöglichkeit bereitzustellen. Die Aufgabe wird erfindungsgemäß durch die Merkmale des Patentanspruchs 1 gelöst, während vorteilhafte Ausgestaltungen und Weiterbildungen der Erfindung den Nebenansprüchen und Unteransprüchen entnommen werden können.

Die Erfindung geht aus von einer Bedienvorrichtung eines Haushaltsgeräts, insbesondere von einer Kochfeldbedienvorrichtung, mit einer Bedienmitteleinheit, die wenigstens ein Magnetmittel und wenigstens ein Funktionsfeld aufweist, das zur lösbaren Kopplung mit wenigstens einer weiteren Bedienmitteleinheit vorgesehen ist.

Es wird vorgeschlagen, dass das Magnetmittel sich zumindest ringsegmentförmig in Umfangsrichtung des Funktionsfelds erstreckt. Unter einem "Funktionsfeld" soll insbesondere ein Feld verstanden werden, mit welchem und/oder auf welchem eine abnehmbare Bedienmitteleinheit bzw. ein abnehmbares Bedienmittel in einem funktionsmäßig gekoppelten Zustand zumindest teilweise aufliegt, wobei in dem Zustand insbesondere eine auf Elektrizität beruhende Kraft auf das Bedienmittel wirken kann, und/oder welches gezielt dazu vorgesehen ist, eine Position und/oder Bewegung des Bedienmittels zu sensieren. Unter einer "auf Elektrizität beruhenden Kraft" soll insbesondere eine magnetische Kraft und/oder eine elektrostatische Kraft verstanden werden. Unter "vorgesehen" soll insbesondere speziell ausgestattet und/oder ausgelegt verstanden werden. Unter einem "funktionsmäßig gekoppelten Zustand" eines Bedienmittels soll insbesondere ein Betriebszustand des Bedienmittels verstanden werden, in welchem ein Bediener durch ein Betätigen des Bedienmittels, welches insbesondere ein Drücken und/oder ein Drehen und/oder ein Schieben des Bedienmittels ist, einen Bedienvorgang durchführen kann. Das Bedienmittel ist dabei vorzugsweise achsenlos, wellenlos und zerstörungsfrei ablösbar auf der Bedienmittelträgereinheit gelagert.

Unter "sich zumindest ringsegmentförmig in Umfangsrichtung erstreckt" soll insbesondere verstanden werden, dass das Magnetmittel bezogen auf eine Drehachse des Funktionsfelds in seinem inneren Bereich eine Ausnehmung aufweist und in Umfangsrichtung eines sich um die Drehachse des Funktionsfelds erstreckenden Kreises eine Erstreckungskomponente aufweist, die zumindest doppelt so groß ist wie zumindest eine Erstreckungskomponente des Magnetmittels in radialer Richtung zur Drehachse. Das Magnetmittel kann vieleckig und/oder vorteilhaft gebogen, insbesondere besonders bevorzugt rund, ausgebildet sein. Ferner kann das Magnetmittel von einem Magneten selbst und/oder zumindest teilweise von einem Leitmittel gebildet sein, das dazu vorgesehen ist, mit einem Magneten gekoppelt zu werden und/oder magnetische Feldlinien zu leiten, und zwar insbesondere in Umfangsrichtung des Funktionsfelds. Das Magnetmittel kann vorteilhaft ein Sensormittel und/oder ein Haltemittel, insbesondere ein Rastmittel, bilden. Durch eine entsprechende Ausgestaltung können konstruktiv einfach Magnetfelder erreicht werden, die für eine Signalerzeugung und/oder für eine Haltekrafterzeugung vorteilhaft genutzt werden können, und zwar insbesondere, wenn das Magnetmittel in Umfangsrichtung differierende Pole aufweist.

Die Bedienmitteleinheit mit dem Magnetmittel ist von einer Bedienmittelträgereinheit gebildet, die zur Kopplung mit einem abnehmbaren Bedienmittel vorgesehen ist, und/oder kann vorteilhaft von einem abnehmbaren Bedienmittel gebildet sein, das zur Kopplung mit einer Bedienmittelträgereinheit vorgesehen ist.

Ferner kann eine Signalauswertung und ein Bedienkomfort verbessert werden, wenn das Magnetmittel zumindest zwei Pole aufweist, die, und zwar insbesondere deren radial nach außen und/oder nach innen weisenden Wirkflächen, in radialer Richtung zur Drehachse des Funktionsfelds unterschiedlich beabstandet sind.

Ferner wird eine Bedienvorrichtung eines Haushaltsgeräts, insbesondere eine Kochfeldbedienvorrichtung, mit einer Bedienmittelträgereinheit vorgeschlagen, die wenigstens ein Funktionsfeld aufweist, das zur Kopplung mit einem abnehmbaren Bedienmittel vorgesehen ist, wobei die Bedienmittelträgereinheit wenigstens ein Konturelement zur Realisierung wenigstens einer von einer Drehbewegung abweichenden Bedienfunktion aufweist. Dabei soll unter einem "Konturelement" insbesondere ein Element verstanden werden, welches eine Erhöhung und/oder vorzugsweise eine Vertiefung bildet, das zur Sensierung einer Druckkraft vorgesehen ist und/oder das, insbesondere zur Sensierung der Druckkraft, formveränderlich und/oder beweglich angeordnet ist. Unter einer "beweglichen Anordnung" soll dabei insbesondere verstanden werden, dass das Konturelement selbst gezielt zur elastischen Verformung vorgesehen ist und/oder dass das Konturelement mittels eines Lagermittels beweglich gelagert ist, wobei die bewegliche Anordnung in der Weise ausgestattet ist, dass eine dadurch ermöglichte Bewegung und/oder Positionsänderung von vorgesehenen Sensoren bei einer Bedienung sensiert werden können. Durch eine entsprechende Ausgestaltung kann eine vorteilhafte Signalauswertung erreicht werden.

Das Konturelement kann zur Realisierung verschiedener, dem Fachmann als sinnvoll erscheinender Bedienfunktionen vorgesehen sein, wie zu einer Drückfunktion, z.B. in Richtung einer Rotationsachse des Bedienmittels in seinem funktionsgemäß gekoppelten Zustand, einer Schiebefunktion, z.B. indem das Konturelement eine Seitenführung bildet und das Bedienmittel in senkrechter Richtung zu der Rotationsachse des Bedienmittels, beispielsweise entlang einer Vorderkante einer Kochfeldplatte, führt, und/oder besonders vorteilhaft zur Realisierung einer Kippfunktion, wodurch bei geringem Platzbedarf vorteilhaft Zusatzfunktionen integriert werden können.

Weist das Konturelement eine Schrägfläche auf, die in einem funktionsgemäßen Zustand gegenüber einer horizontalen Ebene einen Winkel ungleich Null einschließt, vorzugsweise einen Winkel größer als 1° und besonders bevorzugt größer als 3°, und/oder weist das Konturelement eine gekrümmte Fläche auf, kann eine besonders vorteilhafte Bewegung, eine vorteilhafte Haptik und eine besonders vorteilhafte Sensierung erreicht werden.

In einer weiteren Ausgestaltung der Erfindung wird vorgeschlagen, dass das Funktionsfeld eine Grundauflagefläche aufweist, die in zumindest einem Bereich einen Abstand in radialer Richtung zu einer Drehachse des Funktionsfelds aufweist, der zumindest 30%, vorzugsweise zumindest 40% und besonders bevorzugt zumindest 50% einer maximalen Erstreckung des Funktionsfelds in radialer Richtung zur Drehachse aufweist. Dabei soll unter einer "Grundauflagefläche" insbesondere eine Auflagefläche verstanden werden, auf der das Bedienmittel in einem funktionsgemäßen Zustand vor einer Kippbewegung aufliegt und/oder die in einer horizontalen Ebene liegt. Unter einer "Drehachse" des Funktionsfelds soll erfindungsgemäß eine mit der Drehachse des Bedienmittels in dessen funktionsgemäßen Zustand übereinstimmende Drehachse verstanden werden, um die das Bedienmittel zur Bedienung einer Einheit, insbesondere einer Kochstelle, gedreht wird. Durch eine entsprechende Ausgestaltung kann eine besonders vorteilhafte Führung des Bedienmittels bei einer Drehbewegung erreicht werden.

Ferner wird vorgeschlagen, dass die Bedienvorrichtung eine Sensoreinheit und eine Auswerteeinheit aufweist, die dazu vorgesehen sind, eine Bewegung und/oder eine Position des Bedienmittels in einem von einem Betätigungsbereich differierenden Bereich, und zwar vorzugsweise an einem dem Betätigungsbereich bezogen auf eine Drehachse des Bedienmittels in einem funktionsgemäßen Zustand gegenüberliegenden Bereich, zu erfassen und auszuwerten. Unter einem "Betätigungsbereich" soll in diesem Zusammenhang insbesondere ein Bereich verstanden werden, in dem das Bedienmittel von einem Bediener betätigt wird, und zwar insbesondere in dem das Bedienmittel von dem Bediener auf die Bedienmittelträgereinheit gedrückt und damit verkippt wird. Durch eine entsprechende Ausgestaltung können vorteilhaft große zu sensierende Wege realisiert und es kann dadurch bedingt eine vorteilhafte Sensierung erzielt werden.

Vorzugsweise weist die Bedienvorrichtung wenigstens einen Drucksensor auf, wodurch eine einfache Sensierung erreicht werden kann. Dabei kann der Drucksensor zumindest teilweise von dem Konturelement selbst gebildet sein und/oder der Drucksensor kann an und/oder in dem Konturelement angeordnet sein. Besonders bevorzugt ist der Drucksensor von einem Piezosensor gebildet, wie von einer Piezopille und/oder vorzugsweise von einer Piezofolie. Grundsätzlich sind jedoch auch andere, dem Fachmann als sinnvoll erscheinende Sensoren denkbar, wie vorzugsweise Verformungssensoren, z.B. Dehnmessstreifen, Strahlungssensoren, z.B. Infrarotsensoren, usw.

In einer weiteren Ausgestaltung der Erfindung wird vorgeschlagen, dass die Bedienvorrichtung wenigstens eine lokale Erhöhung in einer Kippauflagefläche aufweist. Unter einer "Kippauflagefläche" soll insbesondere eine Fläche verstanden werden, die im Falle eines Kippvorgangs mit einer korrespondierenden Kippauflagefläche in Anlage kommt. Durch eine entsprechende Ausgestaltung kann eine vorteilhafte Konzentration einer Betätigungskraft auf eine gegenüber einer Bedienvorrichtung ohne lokale Erhöhung reduzierte Fläche erreicht und es kann ein vorteilhaftes Signal erzielt werden. Die lokale Erhöhung kann dabei an der Bedienmittelträgereinheit und/oder an dem Bedienmittel angeordnet sein. Ferner kann die lokale Erhöhung verschiedene, dem Fachmann als sinnvoll erscheinende Formen aufweisen, wie vorzugsweise abgerundet, insbesondere zumindest kugelsegmentförmig, wobei in Umfangsrichtung vorzugsweise mehrere gleiche und/oder auch verschiedene Erhöhungen vorgesehen sein können und/oder auch eine Erhöhung vorgesehen sein kann, die sich zumindest über einen Großteils des Umfangs erstreckt, beispielsweise eine wulstförmige Erhöhung.

Ferner wird eine Bedienvorrichtung eines Haushaltsgeräts, insbesondere eine Kochfeldbedienvorrichtung, mit einer Bedienmittelträgereinheit vorgeschlagen, die wenigstens ein Funktionsfeld aufweist, das zur Kopplung mit einem abnehmbaren Bedienmittel vorgesehen ist, wobei die Bedienmittelträgereinheit wenigstens ein Widerstandsreduzierungsmittel aufweist, das zur Reduzierung eines Signalwiderstands und/oder eines Haltekraftwiderstands vorgesehen ist. Unter einem "Signalwiderstand" soll dabei insbesondere ein Widerstand für ein Sensorsignal verstanden werden, das dazu vorgesehen ist, eine Bewegung und/oder eine Position des abnehmbaren Bedienmittels zu signalisieren, wie ein optisches Signal, ein magnetisches Signal usw., und unter einem "Haltekraftwiderstand" soll insbesondere ein Widerstand für eine Haltekraft verstanden werden, wie insbesondere eine magnetische Haltekraft, die dazu vorgesehen ist, das abnehmbare Bedienmittel an der Bedienmittelträgereinheit in einer funktionsgemäßen Position und/oder in einer Rastposition, insbesondere in wenigstens einer definierten Drehstellung, zu halten. Durch eine entsprechende Ausgestaltung kann eine vorteilhafte Signalauswertung erreicht werden, und zwar indem besonders deutliche Signale und ein sicherer Halt des Bedienmittels in seiner funktionsgemäßen Position und/oder in einer bestimmten bzw. definierten Rastposition erreicht werden können.

Das Widerstandsreduzierungsmittel kann von verschiedenen, dem Fachmann als sinnvoll erscheinenden Mitteln gebildet sein. Beispielsweise kann die Bedienmittelträgereinheit aus verschiedenen Materialien gebildet sein, wobei das Widerstandsreduzierungsmittel von dem Material mit einem geringeren Signalwiderstand und/oder Haltekraftwiderstand gebildet ist. Besonders vorteilhaft wird das Widerstandsreduzierungsmittel jedoch von wenigstens einer Ausnehmung gebildet. Dabei soll unter einer "Ausnehmung" insbesondere ein Bereich mit einer gegenüber einem anderen, insbesondere angrenzenden, Bereich reduzierten Materialstärke verstanden werden und/oder ein Bereich, in dem ein Sensormittel und/oder ein Haltemittel innerhalb eines Materials der Bedienmittelträgereinheit angeordnet ist, beispielsweise indem das Sensormittel und/oder das Haltemittel bei einer Herstellung der Bedienmittelträgereinheit in eine Form zur Herstellung der Bedienmittelträgereinheit eingelegt wird, oder indem das Sensormittel und/oder das Haltemittel in die Ausnehmung eingesetzt wird, und/oder eine Ausnehmung auf einer einem Sensormittel und/oder Haltemittel gegenüberliegenden Seite der Bedienmittelträgereinheit. Besonders vorteilhaft ist die Ausnehmung durch einen spanlosen und/oder zerspanenden Umformvorgang in die Bedienmittelträgereinheit eingebracht. Mittels einer Ausnehmung kann das Widerstandsreduzierungsmittel besonders einfach und kostengünstig erreicht werden.

Wird das Widerstandsreduzierungsmittel von wenigstens zwei Ausnehmungen gebildet, kann dies besonders vorteilhaft auf seine Funktion ausgelegt werden, und zwar besonders vorteilhaft, wenn das Widerstandsreduzierungsmittel von wenigstens zwei auf gegenüberliegenden Seiten der Bedienmittelträgereinheit angeordneten Ausnehmungen gebildet ist.

Ferner wird vorgeschlagen, dass wenigstens eine zumindest teilweise das Widerstandsreduzierungsmittel bildende Ausnehmung einen Bedienmittelaufnahmebereich für das Bedienmittel bildet. Dabei soll unter einem "Bedienmittelaufnahmebereich" insbesondere ein Bereich verstanden werden, in den das Bedienmittel eingesetzt werden kann, so dass dieses zumindest teilweise seitlich von der Bedienmittelträgereinheit begrenzt ist. Durch eine entsprechende Ausgestaltung können mit einer Ausnehmung vorteilhaft verschiedene Funktionen realisiert werden, wie insbesondere eine Aufnahme und/oder Führungsfunktion und eine Widerstandsreduzierungsfunktion.

Ferner wird eine Bedienvorrichtung eines Haushaltsgeräts, insbesondere eine Kochfeldbedienvorrichtung, mit einer Bedienmittelträgereinheit vorgeschlagen, die wenigstens ein Funktionsfeld aufweist, das zur Kopplung mit einem abnehmbaren Bedienmittel vorgesehen ist, wobei die Bedienmittelträgereinheit wenigstens einen Bedienmittelaufnahmebereich aufweist, in dem das Bedienmittel in einem funktionsgemäßen Zustand angeordnet ist, und wenigstens einen Funktionsmittelaufnahmebereich aufweist, der seitlich neben dem Bedienmittelaufnahmebereich angeordnet ist. Dabei soll unter "seitlich neben" insbesondere verstanden werden, dass der Funktionsmittelaufnahmebereich in einem funktionsgemäßen Zustand des Bedienmittels in Richtung einer Drehachse des Bedienmittels, um welche das Bedienmittel zur Bedienung einer Einheit gedreht wird, seitlich neben dem Bedienmittelaufnahmebereich angeordnet ist. Dabei kann der Funktionsmittelaufnahmebereich in Richtung der Drehachse oberhalb und/oder unterhalb des funktionsgemäß angeordneten Bedienmittels bzw. des Bedienmittelaufnahmebereichs angeordnet sein und/oder besonders vorteilhaft in einem Bereich des Bedienmittels bzw. des Bedienmittelaufnahmebereichs, so dass wenigstens eine senkrecht zur Drehachse verlaufende Ebene sowohl durch den Bedienmittelaufnahmebereich als auch durch den Funktionsmittelaufnahmebereich verläuft. Ferner soll unter einem "Funktionsmittelaufnahmebereich" insbesondere ein Bereich verstanden werden, der gezielt dazu vorgesehen ist, ein Sensormittel und/oder ein Haltemittel aufzunehmen. Durch eine entsprechende Ausgestaltung können vorteilhafte Wechselwirkungen zwischen korrespondierenden Sensormitteln und/oder Haltemitteln erreicht werden, insbesondere indem vorteilhafte Abstände zwischen den Mitteln einfach realisiert werden können, wodurch eine vorteilhafte Signalauswertung erreichbar ist.

Ist der Funktionsmittelaufnahmebereich dazu vorgesehen, d.h. insbesondere speziell ausgestattet, ausgelegt und insbesondere speziell angeordnet, wenigstens ein erstes Funktionsmittel für ein erstes Bedienmittel und ein Funktionsmittel für ein zweites Bedienmittel aufzunehmen, können Herstellkosten und Materialkosten eingespart werden. Die Funktionsmittel können dabei von verschiedenen, dem Fachmann als sinnvoll erscheinenden Mitteln gebildet sein, wie insbesondere von einem Sensormittel, einem Haltemittel, einem Tragmittel, auf dem Sensormittel und/oder Haltemittel montiert sind, usw., wobei die Funktionsmittel auch zumindest teilweise einstückig ausgebildet sein können.

Ferner wird vorgeschlagen, dass die Bedienvorrichtung wenigstens einen Magneten aufweist, der in radialer Richtung zu einer Drehachse des Funktionsfelds differierende Pole aufweist, wodurch konstruktiv einfach Magnetfelder erreicht werden können, die für einen seitlich neben dem Bedienmittelaufnahmebereich angeordneten Funktionsmittelaufnahmebereich vorteilhaft ausgerichtet sind und für eine Signalerzeugung und/oder für eine Haltekrafterzeugung vorteilhaft genutzt werden können.

Die Bedienvorrichtung kann verschiedene, dem Fachmann als sinnvoll erscheinende Magnete aufweisen, die verschiedenartig, insbesondere auch im Hinblick auf ihre Ausrichtung der Polungen, angeordnet sein können, und auch verschiedene Formen aufweisen können. Vorteilhaft weist die Bedienvorrichtung jedoch zumindest einen Stabmagneten auf, wobei unter einem "Stabmagneten" insbesondere ein Magnet verstanden werden soll, bei dem die magnetischen Pole entlang seiner längsten Erstreckung, insbesondere entlang seiner Symmetrieachse, liegen. Mittels entsprechender Magnete können Platz sparend einfach vorteilhafte Magnetfelder erreicht werden, die für eine Signalerzeugung und/oder für eine Haltekrafterzeugung vorteilhaft genutzt werden können. Der Stabmagnet kann vorteilhaft ein Sensormittel und/oder ein Haltemittel, insbesondere ein Rastmittel, bilden.

In einer weiteren Ausgestaltung der Erfindung wird vorgeschlagen, dass die Bedienvorrichtung wenigstens ein magnetisierbares Leitmittel aufweist, das in einem funktionsgemäßen Zustand zur Weiterleitung magnetischer Feldlinien in radialer Richtung zu einer Drehachse des Funktionsfelds und/oder des Bedienmittels vorgesehen ist. Unter einem magnetisierbaren "Leitmittel" soll insbesondere ein Mittel verstanden werden, das zur Kontaktierung mit einem Magneten vorgesehen ist, selbst jedoch kein Magnet bzw. Dauermagnet ist, und das vorzugsweise von einem Blechteil gebildet ist. Das Leitmittel kann vorteilhaft ein Sensormittel und/oder ein Haltemittel, insbesondere ein Rastmittel bilden. Durch eine entsprechende Ausgestaltung können wiederum vorteilhafte Magnetfelder erreicht werden, die für eine Signalerzeugung und/oder für eine Haltekrafterzeugung vorteilhaft genutzt werden können, wodurch insgesamt eine vorteilhafte Signalauswertung erreichbar ist.

Weist die Bedienvorrichtung zumindest ein zweites Leitmittel auf, kann eine besonders vorteilhafte Weiterleitung von Feldlinien erreicht werden. Insbesondere können vorteilhaft mittels der Leitmittel Feldlinien differierender Pole geleitet werden, und zwar vorzugsweise in radialer Richtung zur Drehachse, so dass ein besonders vorteilhafter magnetischer Fluss und eine damit verbundene vorteilhafte Signalauswertung realisiert werden können.

Dabei kann das abnehmbare Bedienmittel ein oder mehrere Leitmittel umfassen und/oder die Bedienmittelträgereinheit kann ein oder mehrere Leitmittel umfassen.

Die Bedienmittelträgereinheit kann von verschiedenen, dem Fachmann als sinnvoll erscheinenden Bauteilen gebildet sein, wie vorzugsweise von einer Kochfeldplatte, insbesondere einer Glaskeramikplatte, und besonders bevorzugt von einem von der Kochfeldplatte differierenden Bauteil, wie vorzugsweise von einer Bedienblende. Die Bedienblende kann konstruktiv einfach an verschiedene Anforderungen vorteilhaft angepasst werden, insbesondere kann dieselbe gegenüber einer Glaskeramikplatte grundsätzlich einfacher mit Ausnehmungen versehen werden. Die Bedienblende kann aus verschiedenen, dem Fachmann als sinnvoll erscheinenden Materialien gebildet sein, wie aus Kunststoff und/oder besonders vorteilhaft zumindest teilweise aus Metall, wie bevorzugt aus Aluminium.

Erfindungsgemäß umfasst die Bedienvorrichtung wenigstens ein abnehmbares Bedienmittel, das zur Kopplung mit dem Funktionsfeld vorgesehen ist, und welches Bedienmittel in einem funktionsmäßig gekoppelten Zustand über wenigstens eine Seitenkontur und insbesondere über wenigstens eine Deckfläche der Bedienmittelträgereinheit hinausragt. Dabei soll unter einer "Seitenkontur" insbesondere eine, im montierten Zustand in einer Draufsicht entlang einer Rotationsachse des Bedienmittels betrachtet, seitliche Begrenzungslinie der Bedienmittelträgereinheit verstanden werden und unter einer "Deckfläche" soll insbesondere eine, im montierten Zustand in einer Draufsicht entlang einer Rotationsachse des Bedienmittels betrachtet, von einer Funktionsauflagefläche des Funktionsfelds abweichende, einem Betrachter zugewandte Fläche verstanden werden. Im montierten Zustand ragt das Bedienmittel vorteilhaft zumindest in einem Bereich zumindest 1 mm und vorteilhaft zumindest 2 mm über die Seitenkontur und/oder über die Deckfläche hinaus. Durch eine entsprechende Ausgestaltung kann eine besonders vorteilhafte Bedienung des Bedienmittels an einem sich über die Seitenkontur und/oder über die Deckfläche hinaus erstreckenden Teilbereich des Bedienmittels ermöglicht werden.

Vorteilhaft ist das Bedienmittel dabei im funktionsmäßig gekoppelten Zustand in radialer Richtung zu seiner Drehachse zumindest in Richtung der Seitenkontur mittels der Bedienmittelträgereinheit gesichert bzw. in seiner Bewegung begrenzt, und zwar vorzugsweise durch eine Kontur der Bedienmittelträgereinheit, wie besonders bevorzugt durch einen Randbereich eines Bedienmittelaufnahmebereichs der Bedienmittelträgereinheit. Vorzugsweise erstreckt sich der Randbereich des Bedienmittelaufnahmebereichs bezogen auf die Drehachse des Bedienmittels in dessen funktionsmäßig gekoppelten Zustand über mehr als 180° und über weniger als 360°, und/oder der Bedienmittelaufnahmebereich ist in zumindest einem Bereich zumindest teilweise ohne Randbereich ausgebildet, so dass das Bedienmittel in diesem Bereich an seiner Stirnseite von einem Bediener kontaktiert werden kann. Ferner ist der Randbereich vorzugsweise kreisförmig ausgebildet, wodurch eine vorteilhafte Führung des Bedienmittels erreicht werden kann.

Ferner wird vorgeschlagen, dass das Funktionsfeld zur Bedienung von zumindest zwei Kochstellen vorgesehen ist, wodurch Platz eingespart und ein vorteilhafter Bedienkomfort erreicht werden können. Dabei weist die Bedienvorrichtung vorzugsweise eine entsprechende dazu vorgesehene Steuer- und/oder Regeleinheit auf, d.h. insbesondere eine Einheit mit einer Recheneinheit, einer Speichereinheit und einem in der Speichereinheit gespeicherten Betriebsprogramm.

Weitere Vorteile ergeben sich aus der folgenden Zeichnungsbeschreibung. In der Zeichnung sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: einen schematisiert dargestellten Ausschnitt eines Kochfelds mit einer Kochfeldbedienvorrichtung,
- Fig. 2: einen Ausschnitt einer Draufsicht der Kochfeldbedienvorrichtung aus Figur 1,
- Fig. 3: einen schematisiert dargestellten Schnitt entlang der Linie III-III in Figur 2,
- Fig. 3a: einen vergrößerten Ausschnitt aus Figur 3,
- Fig. 4: eine Explosionsdarstellung eines Bedienmittels der Kochfeldbedienvorrichtung,
- Fig. 5: einen schematisiert dargestellten Schnitt durch eine alternative Kochfeldbedienvorrichtung mit Drucksensoren,
- Fig. 6: eine Draufsicht auf eine alternative Kochfeldbedienvorrichtung mit einem einzelnen Bedienmittel,
- Fig. 7: einen schematisiert dargestellten Schnitt durch eine alternative Kochfeldbedienvorrichtung mit Bedienmitteln, die abgewinkelte Leitmittel umfassen,
- Fig. 8: eine Draufsicht auf eine alternative Kochfeldbedienvorrichtung mit einem Bedienmittel, das ein rechtwinklig abgewinkeltes Leitmittel umfasst,
- Fig. 9: einen schematisiert dargestellten Schnitt entlang der Linie IX-IX in Figur 8,
- Fig. 10: eine Draufsicht auf eine alternative Kochfeldbedienvorrichtung mit einem Bedienmittel, das ein ringförmiges Magnetmittel umfasst, und
- Fig. 11: eine Draufsicht auf eine alternative Kochfeldbedienvorrichtung mit einem Bedienmittel, das Stabmagnete umfasst.

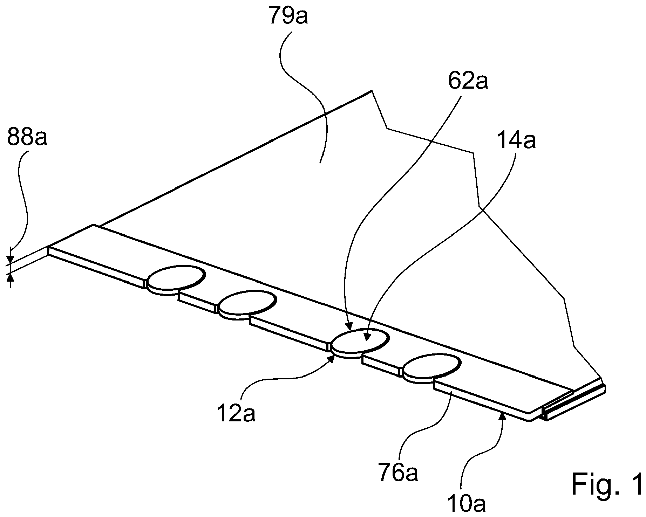

Fig. 1 zeigt einen schematisiert dargestellten Ausschnitt eines Kochfelds mit einer Kochfeldbedienvorrichtung. Die Kochfeldbedienvorrichtung umfasst eine von einer Bedienblende gebildete Bedienmittelträgereinheit 10a. Die Bedienmittelträgereinheit 10a ist von einem von einer Kochfeldplatte 79a getrennt ausgebildeten Bauteil gebildet, und zwar ist die Bedienmittelträgereinheit 10a von einer Aluminiumleiste gebildet, die in einem vorderen Randbereich der Kochfeldplatte 79a an dieselbe angeklebt ist. Die Bedienmittelträgereinheit 10a umfasst vier Funktionsfelder 12a, die jeweils zur Kopplung mit einem abnehmbaren Bedienmittel 14a der Kochfeldbedienvorrichtung vorgesehen sind. Jedes der Funktionsfelder 12a ist zur Bedienung einer einzelnen Kochstelle des Kochfelds vorgesehen (Figuren 1 bis 3a). Die Bedienmittel 14a sind in einem funktionsgemäßen Zustand in Bedienmittelaufnahmebereichen 62a angeordnet, die von runden Ausnehmungen 52a in der Bedienmittelträgereinheit 10a gebildet sind. Die Ausnehmungen 52a sind durch ein zerspanendes Umformverfahren in die Bedienmittelträgereinheit 10a eingebracht, und zwar durch ein Fräsverfahren. Die Bedienmittel 14a ragen in dem dargestellten, funktionsmäßig gekoppelten Zustand über eine Seitenkontur 76a und über eine Deckfläche 78a der Bedienmittelträgereinheit 10a hinaus, und zwar mit einer Erstreckung von ca. 5 mm, so dass eine Bedienung der Bedienmittel 14a an deren Stirnseite möglich ist. Die Seitenkontur 76a bildet eine einem vor der Kochfeldbedienvorrichtung stehenden Bediener zugewandte Vorderkante der Bedienmittelträgereinheit 10a. Die Bedienmittel 14a sind im funktionsmäßig gekoppelten Zustand in radialer Richtung 74a zu ihren Drehachsen 32a in Richtung der Seitenkontur 76a mittels der Bedienmittelträgereinheit 10a gesichert bzw. in ihrer Bewegung begrenzt, und zwar jeweils durch einen kreisförmigen Randbereich der Bedienmittelaufnahmebereiche 62a der Bedienmittelträgereinheit 10a. Die Randbereiche der Bedienmittelaufnahmebereiche 62a erstrecken sich bezogen auf die Drehachse 32a der Bedienmittel 14a jeweils über mehr als 180° und über weniger als 360°, wodurch die Bedienmittel 14a jeweils in sämtliche radiale Richtungen 74a zur Drehachse 32a innerhalb der Bedienmittelaufnahmebereiche 62a gesichert bzw. in ihren Bewegungen begrenzt sind und dennoch eine vorteilhafte Bedienung an den über die Seitenkontur 76a überstehenden Teilbereichen der Bedienmittel 14a ermöglicht wird.

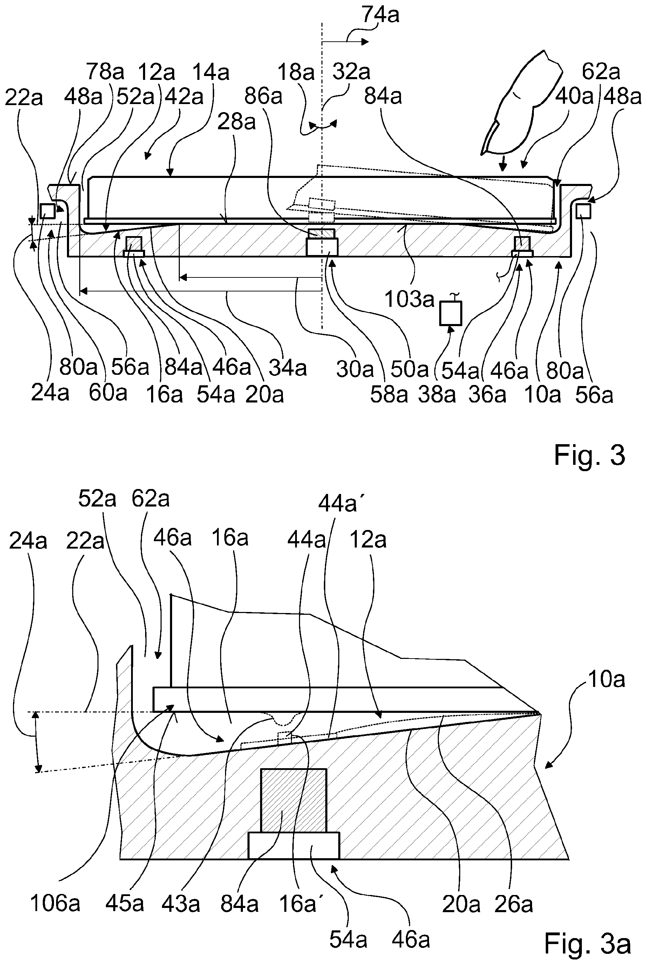

Die Bedienmittel 14a sind in den Bedienmittelaufnahmebereichen 62a in ihren Drehbewegungen 18a um ihre Drehachsen 32a geführt, mittels der eine Einstellung der jeweiligen Kochstellen vorgenommen werden kann. Um von der Drehbewegung 18a abweichende Bedienfunktionen zu realisieren, weist die Bedienmittelträgereinheit 10a Konturelemente 16a zur Realisierung von Kippfunktionen auf (Figuren 3 und 3a). Die Konturelemente 16a weisen jeweils eine in einem Bodenbereich der Bedienmittelaufnahmebereiche 62a angeordnete Schrägflächen 20a auf, die in einem funktionsgemäßen Zustand der Bedienmittelträgereinheit 10a gegenüber einer horizontalen Ebene 22a einen Winkel 24a von ca. 20° einschließt und die sich ringförmig um eine von einer Kreisfläche gebildete Grundauflagefläche 28a des Funktionsfelds 12a erstreckt, die ebenfalls im Bodenbereich des Bedienmittelaufnahmebereichs 62a angeordnet ist. Die Schrägfläche 20a ist geradlinig, grundsätzlich wäre jedoch auch eine gewölbte Fläche 26a denkbar, wie dies in Figur 3a angedeutet ist.

Die Grundauflagefläche 28a weist in ihrem äußeren Randbereich einen Abstand 30a in radialer Richtung 74a zu der Drehachse 32a des Funktionsfelds 12a auf bzw. weist einen Radius auf, der ca. 50% einer maximalen Erstreckung 34a des Funktionsfelds 12a in radialer Richtung 74a zur Drehachse 32a aufweist, wobei die maximale Erstreckung 34a des Funktionsfelds 12a einem Radius des Bedienmittelaufnahmebereichs 62a entspricht.

Die Bedienmittelträgereinheit 10a weist von jeweils zwei Ausnehmungen 52a - 58a gebildete Widerstandsreduzierungsmittel 46a - 50a auf, die zur Reduzierung von Signalwiderständen und von Haltekraftwiderständen vorgesehen sind. Die Widerstandsreduzierungsmittel 46a - 50a werden von Bereichen gebildet, die gegenüber einer grundlegenden Stärke 88a von ca. 8 mm der Bedienmittelträgereinheit 10a eine reduzierte Materialstärke von weniger als 4 mm aufweisen.

Die jeweils einen ersten Teil die Widerstandsreduzierungsmittel 46a - 50a bildende Ausnehmung 52a bildet den Bedienmittelaufnahmebereich 62a für das Bedienmittel 14a. In denen auf einer der Ausnehmung 52a abgewandten Seite der Bedienmittelträgereinheit 10a angeordneten, jeweils einen zweiten Teil der Widerstandsreduzierungsmittel 46a bildenden, bezüglich der Drehachse 32a diametral gegenüberliegenden Ausnehmungen 54a sind von Magnetsensoren, und zwar von MR-Sensoren (Magnetoresistive-Sensoren) gebildete Funktionsmittel 84a angeordnet. In denen auf der der Ausnehmung 52a abgewandten Seite der Bedienmittelträgereinheit 10a angeordneten, einen zweiten Teil der Widerstandsreduzierungsmittel 48a bildenden Ausnehmungen 56a sind von Magneten gebildete Funktionsmittel 80a angeordnet, die dazu vorgesehen sind, eine Haltekraft, und zwar eine magnetische Rastkraft in Umfangsrichtung 68a des Bedienmittels 14a, zu erzeugen. In der auf der der Ausnehmung 52a abgewandten Seite der Bedienmittelträgereinheit 10a angeordneten, einen zweiten Teil des Widerstandsreduzierungsmittels 50a bildenden Ausnehmung 58a, die koaxial zur Drehachse 32a angeordnet ist, ist ein von einem Magnet gebildetes Funktionsmittel 86a angeordnet, das dazu vorgesehen ist, das Bedienmittel 14a zu zentrieren und in Richtung der Drehachse 32a in den Bedienmittelaufnahmebereich 62a zu ziehen.

Die Ausnehmungen 56a bilden Funktionsmittelaufnahmebereiche 60a, die seitlich neben dem Bedienmittelaufnahmebereich 62a angeordnet sind. Die Ausnehmungen 56a erstrecken sich parallel zur Drehachse 32a, ausgehend von einer der Deckfläche 78a abgewandten Seite der Bedienmittelträgereinheit 10a über eine durch die Grundauflagefläche 28a aufgespannte Ebene hinaus, so dass die Funktionsmittel 80a in einer senkrecht zur Drehachse 32a ausgebildeten Ebene angeordnet werden können, die durch den Bedienmittelaufnahmebereich 62a verläuft.

Zusätzlich oder alternativ zu MR-Sensoren sind auch Hall-Sensoren und/oder andere, dem Fachmann als sinnvoll erscheinende Sensoren denkbar, wie Strahlungssensoren, wie vorzugsweise Infrarotsensoren usw., die zumindest teilweise in der Ausnehmung 52a angeordnet sein können, und/oder Drucksensoren 44a, 44a' die selbst Konturelemente 16a' bilden, wie dies in Figur 3a angedeutet ist. Dabei können verschiedene Drucksensoren 44a, 44a' eingesetzt werden, jedoch besonders vorteilhaft Piezosensoren, wie beispielsweise als Piezopille ausgebildete Drucksensoren 44a und/oder als Piezofolie ausgebildete Drucksensoren 44a'. Werden Drucksensoren 44a, 44a' verwendet, können vorteilhaft in einer Kippauflagefläche 45a des Bedienmittels 14a über den Umfang gleichmäßig verteilt angeordnete, kugelsegmentartige, lokale Erhöhungen 43a vorgesehen sein. Die Drucksensoren 44a, 44a' können vorteilhaft auf die Bedienmittelträgereinheit 10a aufgeklebt sein.

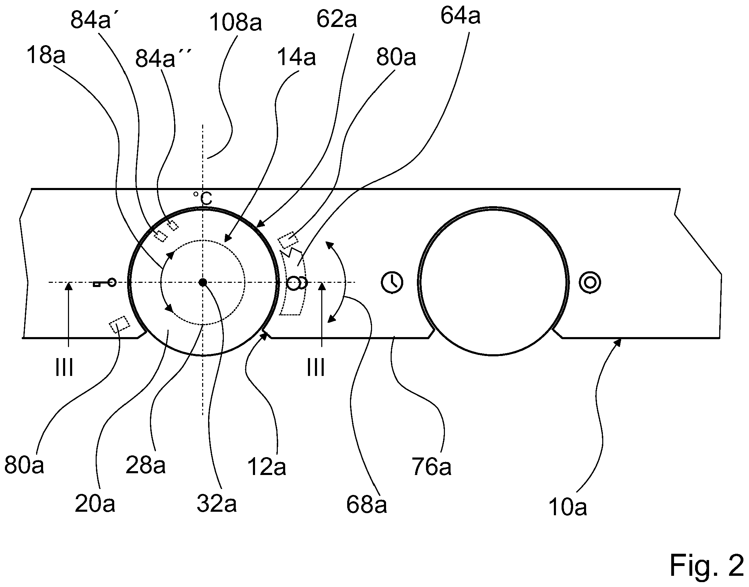

Die zwei seitlich auf zwei gegenüberliegenden Seiten neben dem Bedienmittelaufnahmebereich 62a angeordneten Funktionsmittel 80a werden von Stabmagneten gebildet, die in radialer Richtung zur Drehachse 32a des Funktionsfelds 12a differierende Pole S, N aufweisen. Alternativ und/oder zusätzlich zu den Stabmagneten könnte auch ein Magnetmittel 64a innerhalb der Bedienmittelträgereinheit 10a angeordnet sein, das sich ringförmig in Umfangsrichtung 68a des Funktionsfelds 12a erstreckt und in Umfangsrichtung 68a differierende Pole N, S aufweist, wie dies in Figur 2 schematisch angedeutet ist.

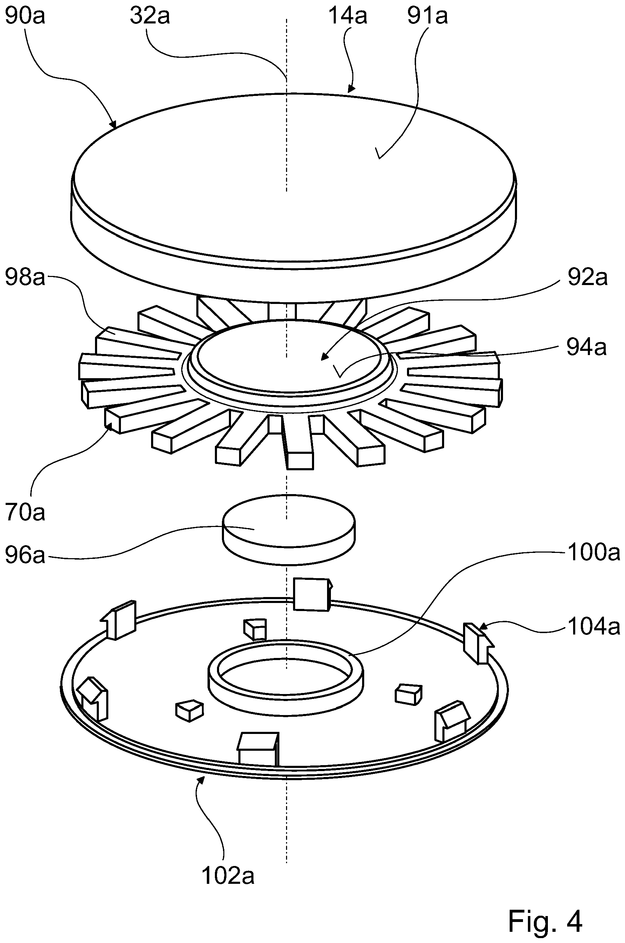

Das scheibenförmige Bedienmittel 14a umfasst einen topfförmigen Deckel 90a, der eine ebene Deckfläche 91a bildet (Figur 4). Der Deckel 90a ist aus Kunststoff und ist in einer gewünschten Farbe lackiert. In einem vom Deckel 90a gebildeten inneren Aufnahmebereich ist ein magnetisierbares Leitmittel 70a des Bedienmittels 14a angeordnet, das in einem funktionsgemäßen Zustand zur Weiterleitung magnetischer Feldlinien in radialer Richtung 74a zur Drehachse 32a des Funktionsfelds 12a und des Bedienmittels 14a vorgesehen ist. Das Leitmittel 70a wird von einem Biegestanzteil aus Blech gebildet. Das Leitmittel 70a weist einen inneren, rundflächigen Bereich 92a auf, der an seiner zum Deckel 90a weisenden Seite eine Anlagefläche 94a bildet, mit der das Leitmittel 70a im montierten Zustand an einer Innenseite des Deckels 90a anliegt. An seiner dem Deckel 90a abgewandten Seite bildet der Bereich 92a eine Anlagefläche, mit der das Leitmittel 70a im montierten Zustand an einer Deckseite eines scheibenförmigen Magneten 96a anliegt, der dazu vorgesehen ist, das Leitmittel 70a zu magnetisieren bzw. dessen Magnetfeldlinien mittels des Leitmittels 70a radial nach außen geleitet werden. Hierzu weist das Leitmittel 70a ausgehend von dem Bereich 92a sich radial nach außen erstreckende, über den Umfang gleichmäßig verteilte Arme 98a auf, und zwar 18 Stück. Die Arme 98a wirken im funktionsgemäß angeordneten Zustand des Bedienmittels 14a mit den von MR-Sensoren gebildeten Funktionsmitteln 84a zur Erzeugung von Einstellsignalen und mit den seitlich neben dem Bedienmittelaufnahmebereich 62a angeordneten Funktionsmitteln 80a zur Erzeugung von Rastkräften zusammen. Der Magnet 96a wirkt mit dem Funktionsmittel 86a zusammen, um eine Haltekraft in Richtung der Drehachse 32a zu erzeugen. Die bezogen auf die Drehachse 32a diametral gegenüberliegenden MR-Sensoren dienen gemeinsam mit den Armen 98a dazu, Einstellsignale bei einer Drehbewegung des Bedienmittels 14a als auch bei einer Kippbewegung des Bedienmittels 14a zu erzeugen. Zur Erfassung einer Drehbewegung können jedoch auch zusätzlich zu den Funktionsmitteln 84a von Sensoren, insbesondere von MR-Sensoren, gebildete Funktionsmittel 84a', 84a" vorgesehen sein, die vorzugsweise in einem gemeinsamen Kreisquadranten angeordnet sein können, wie dies schematisch in Figur 2 dargestellt ist. Die Funktionsmittel 84a', 84a" sind unterhalb des Bedienmittelaufnahmebereichs 62a angeordnet.

Die Bedienvorrichtung weist eine die MR-Sensoren umfassende Sensoreinheit 36a und eine Auswerteeinheit 38a auf, die dazu vorgesehen sind, eine Bewegung des Bedienmittels 14a in einem von einem Betätigungsbereich 40a differierenden Bereich 42a, und zwar jeweils einem dem Betätigungsbereich 40a bezogen auf die Drehachse 32a gegenüberliegenden Bereich 42a, zu erfassen und auszuwerten (Figur 3). Bei einer Kippbewegung wird ein sich aus einem zunehmenden Abstand parallel zur Drehachse 32a zwischen dem Leitmittel 70a und den MR-Sensoren auf einer dem Betätigungsbereich 40a gegenüberliegenden Bereich 42a ergebendes Signal mittels der Auswerteeinheit 38a ausgewertet.

Besonders vorteilhaft ist eine Kippachse 108a senkrecht zu einer Vorderkante bzw. zu einer Längserstreckung der Bedienblende vorgesehen, um die das Bedienmittel 14a zur Einstellung geschwenkt werden muss (Figur 2). Grundsätzlich sind jedoch auch andere und insbesondere auch mehrere Kippachsen denkbar. Mittels einer Drehbewegung des Bedienmittels 14a um seine Drehachse 32a können Leistungsstufen ausgewählt werden, während mittels Kippbewegungen verschiedene Größen von Kochstellen, eine Kochzeit, eine Sperrstellung usw. eingestellt werden können. Grundsätzlich sind jedoch auch weitere, dem Fachmann als sinnvoll erscheinende Einstellungen mittels einer Kippbewegung denkbar. Neben dem Bedienmittelaufnahmebereich 62a sind im Bereich der Kippachse 108a Symbole für die Kippfunktionen auf die Bedienmittelträgereinheit 10a aufgedruckt.

Der scheibenförmige Magnet 96a ist im montierten Zustand in einem kreisringförmigen Haltemittel 100a eines Bodendeckels 102a angeordnet (Figur 4). Der Bodendeckel 102a weist angeformte, hakenförmige Rastmittel 104a auf, mittels denen der Bodendeckel 102a in den Deckel 90a im montierten Zustand eingerastet ist. Der Bodendeckel 102a weist einen größeren Durchmesser auf als der Deckel 90a, so dass dieser in radialer Richtung über Seitenwandungen des Deckels 90a übersteht (vgl. Figur 3 und 3a). Ein dadurch resultierender Überstand 106a ist dazu vorgesehen, einen Kontakt zwischen dem Deckel 90a und dem Randbereich des Bedienmittelaufnahmebereichs 62a möglichst weitgehend zu vermeiden, wodurch eine Lackbeschädigung des Deckels 90a vermieden werden kann. Um eine vorteilhafte Drehbarkeit zu erreichen, weist der Bodendeckel 102a eine leicht konkave, insbesondere kegelartige, Auflagefläche 103a auf (Figur 3).

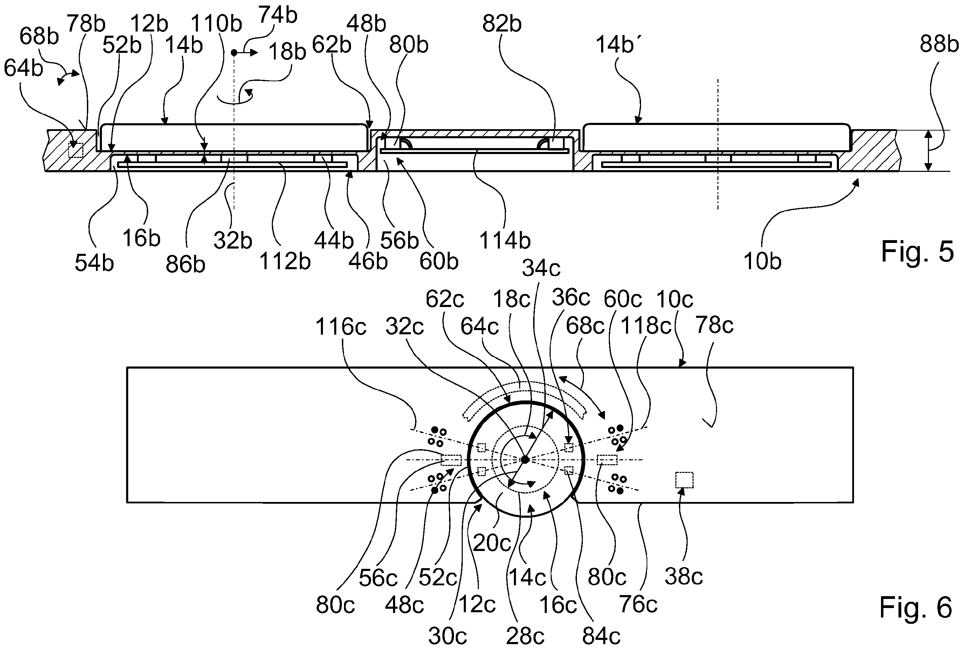

In den Figuren 5 bis 11 sind alternative Ausführungsbeispiele dargestellt. Im Wesentlichen gleich bleibende Bauteile, Merkmale und Funktionen sind grundsätzlich mit den gleichen Bezugszeichen beziffert. Zur Unterscheidung der Ausführungsbeispiele sind jedoch den Bezugszeichen der Ausführungsbeispiele die Buchstaben a bis g hinzugefügt. Die nachfolgende Beschreibung beschränkt sich im Wesentlichen auf die Unterschiede zu dem Ausführungsbeispiel in den Figuren 1 bis 4, wobei bezüglich gleich bleibender Bauteile, Merkmale und Funktionen auf die Beschreibung des Ausführungsbeispiels in den Figuren 1 bis 4 verwiesen werden kann. Ferner ist zu beachten, dass alternativ und/oder zusätzlich zu Merkmalen und/oder Funktionen eines der Ausführungsbeispiele auch Merkmale und/oder Funktionen eines anderen der Ausführungsbeispiele vorgesehen sein können.

In Figur 5 ist ein Ausschnitt einer Schnittdarstellung durch eine Kochfeldbedienvorrichtung mit einer von einer Bedienblende gebildeten Bedienmittelträgereinheit 10b dargestellt. Die Bedienmittelträgereinheit 10b weist Konturelemente 16b auf, die zur Realisierung von von einer Drehbewegung 18b um eine Drehachse 32b abweichenden Bedienfunktionen vorgesehen sind, und zwar sind die Konturelemente 16b von materialverjüngten Bereichen der Bedienmittelträgereinheit 10b gebildet, die zur Weiterleitung einer auf ein Bedienmittel 14b ausgeübten Druckkraft an Drucksensoren 44b vorgesehen sind. Das Konturelement 16b bzw. der materialverjüngte Bereich der Bedienmittelträgereinheit 10b wird von einem Wandteil zwischen einer einen Bedienmittelaufnahmebereich 62b bildenden Ausnehmung 52b und einer Ausnehmung 54b gebildet, die der Ausnehmung 52b gegenüberliegend angeordnet ist. Die Ausnehmungen 52b, 54b sind rund und koaxial zur Drehachse 32b angeordnet, wobei die Ausnehmung 54b einen kleineren Durchmesser aufweist als die Ausnehmung 52b. Der Durchmesser der Ausnehmung 52b ist jedoch vorteilhaft größer als 50% und, wie im dargestellten Ausführungsbeispiel gezeigt, größer als 70% des Durchmessers der Ausnehmung 54b, wodurch die Drucksensoren 44b vorteilhaft in einem radial äußeren Bereich des Bedienmittelaufnahmebereichs 62b positioniert werden können. Bedingt durch die unterschiedlichen Durchmesser ergibt sich im Randbereich des Bedienmittelaufnahmebereichs 62b ein vorteilhafter Auflagebereich, der eine größere Wandstärke aufweist als das Wandteil direkt zwischen den Ausnehmungen 52b, 54b. Das Wandteil direkt zwischen den Ausnehmungen 52b, 54b weist eine Wandstärke 110b von weniger als 1 mm auf. Die von Piezosensoren gebildeten Drucksensoren 44b sind bezogen auf die Drehachse 32b diametral gegenüberliegend angeordnet und sind auf einer gemeinsamen Trägerplatte 112b angeordnet. Zusätzlich oder alternativ könnte jedoch auch ein Drucksensor im mittleren Bereich des Bedienmittelaufnahmebereichs 62b angeordnet sein.

Die Kochfeldbedienvorrichtung umfasst einen Funktionsmittelaufnahmebereich 60b, der seitlich neben dem Bedienmittelaufnahmebereich 62b angeordnet ist, und dazu vorgesehen ist, Funktionsmittel 80b für ein erstes Bedienmittel 14b und Funktionsmittel 82b für ein zweites Bedienmittel 14b' aufzunehmen. Der Funktionsmittelaufnahmebereich 60b ist von einer Ausnehmung 56b auf einer dem Bedienmittelaufnahmebereich 62b abgewandten Seite der Bedienmittelträgereinheit 10b gebildet, die gemeinsam mit der Ausnehmung 52b ein Widerstandsreduzierungsmittel 48b bildet. Die Funktionsmittel 80b, 82b sind auf einer gemeinsamen Trägerplatte 114b angeordnet.

Eine Erfassung einer Drehbewegung erfolgt bei dem Ausführungsbeispiel in Figur 5 entsprechend dem in Figur 2 dargestellten Ausführungsbeispiel, und zwar mit zwei nicht näher dargestellten, unterhalb des Bedienmittelaufnahmebereichs 62b angeordneten, von MR-Sensoren gebildeten Funktionsmitteln, die ebenfalls vorzugsweise auf der Trägerplatte 114b befestigt sein können. Alternativ könnten auch von Sensoren gebildete Funktionsmittel seitlich neben dem Bedienmittelaufnahmebereich 62b angeordnet sein, vorzugsweise in dem Funktionsmittelaufnahmebereich 60b.

Figur 6 zeigt eine Kochfeldbedienvorrichtung mit einer von einer Bedienblende gebildeten Bedienmittelträgereinheit 10c. Die Kochfeldbedienvorrichtung umfasst ein einzelnes Bedienmittel 14c und ein einzelnes Funktionsfeld 12c, welche zur Bedienung von mehreren Kochstellen vorgesehen sind. Die Kochfeldbedienvorrichtung entspricht ihrem Aufbau grundsätzlich der Kochfeldbedienvorrichtung aus den Figuren 1 bis 4 und umfasst ein entsprechendes Konturelement 16c zur Realisierung von Kippfunktionen, wobei das Konturelement 16c eine in einem Bodenbereich eines Bedienmittelaufnahmebereichs 62c angeordnete Schrägfläche 20c aufweist. Statt einer Kippachse 108a je Bedienmittel 14a, weist die Kochfeldbedienvorrichtung jedoch vorzugsweise zwei Kippachsen 116c, 118c bezüglich des Bedienmittels 14c auf, unter denen jeweils zwei diametral gegenüberliegend, von Magnetsensoren, und zwar von MR-Sensoren (Magnetoresistive-Sensoren), gebildete Funktionsmittel 84c angeordnet sind. Mittels einfacher Kippbewegungen können die Kochstellen ausgewählt, mittels mehrfacher Kippbewegungen könnten verschiedene Größen bei den Kochstellen ausgewählt werden und mittels einer anschließenden Drehbewegung 18c des Bedienmittels 14c um eine Drehachse 32c können Leistungsstufen der ausgewählten Kochstelle eingestellt werden. Die Kippachsen 116c, 118c schneiden sich mit einem Winkel ungleich 90°, wodurch die Funktionsmittel 84c vorteilhaft positioniert werden können. Grundsätzlich sind auch mehr als zwei Kippachsen 116c, 118c denkbar.

Seitlich neben dem Bedienmittelaufnahmebereich 62c sind Funktionsmittelaufnahmebereiche 60c mit von Magneten gebildeten Funktionsmitteln 80c zur Erzeugung einer magnetischen Rastkraft bzw. einer Haltekraft in definierten Drehstellungen angeordnet.

Ferner umfasst die Kochfeldbedienvorrichtung aus Figur 6 dem Ausführungsbeispiel aus den Figuren 1 bis 4 entsprechende Widerstandsreduzierungsmittel 46c, 48c.

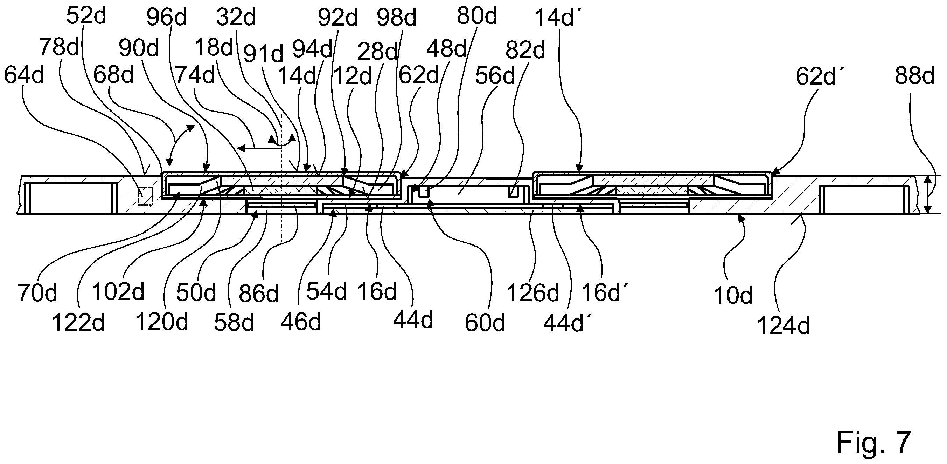

Figur 7 zeigt einen schematisiert dargestellten Ausschnitt einer Schnittdarstellung einer Kochfeldbedienvorrichtung, die im Wesentlichen der Kochfeldbedienvorrichtung aus Figur 5 entspricht. Die Kochfeldbedienvorrichtung umfasst ein Bedienmittel 14d mit einem Leitmittel 70d, welches entsprechend dem Leitmittel 70a, sich ausgehend von einem Bereich 92d in radialer Richtung 74d nach außen erstreckende Arme 98d aufweist. Die Arme 98d weisen zwei Abwinklungen 120d, 122d auf, und zwar bei einer Betrachtung in radialer Richtung 74d nach außen, eine erste Abwinklung 120d in Richtung eines Bodendeckels 102d, nach der sich die Arme 98d schräg in Richtung des Bodendeckels 102d erstrecken, und eine zweite Abwinklung 122d, die der ersten Abwinklung 120d entgegen gerichtet ist, so dass sich die Arme 98d nach der Abwinklung 122d mit zu dem Bodendeckel 102d reduziertem Abstand gegenüber vor den Abwinklungen 120d, 122d im funktionsgemäßen Zustand des Bedienmittels 14d parallel entlang einer inneren Fläche des Bodendeckels 102d erstrecken.

Die Kochfeldbedienvorrichtung umfasst einen Funktionsmittelaufnahmebereich 60d, der von zwei unterschiedlich tiefen, in einem gemeinsamen Abschnitt einer Bedienmittelträgereinheit 10d angeordneten Ausnehmungen 54d, 56d gebildet ist, und zwar einer ersten Ausnehmung 56d, die sich parallel zu einer Drehachse 32d ausgehend von einer von einer untersten Fläche 124d der Bedienmittelträgereinheit 10d aufgespannten Ebene bis über eine von einer Auflagefläche 28d eines Bedienmittelaufnahmebereichs 62d aufgespannten Ebene hinaus erstreckt. Die zweite Ausnehmung 54d erstreckt sich ausgehend von der von der untersten Fläche 124d aufgespannten Ebene bis in eine Ebene, die senkrecht zur Drehachse 32d verläuft, und ausgehend von der von der untersten Fläche 124d aufgespannten Ebene parallel zur Drehachse 32d geringfügig von dem Bedienmittelaufnahmebereich 62d, und zwar mit einem Abstand kleiner 1 mm, beabstandet ist. Die Ausnehmung 54d erstreckt sich parallel zur von der untersten Fläche 124d ausgespannten Ebene bis unter zwei benachbarte Bedienmittelaufnahmebereiche 62d, 62d'. In dem von der Ausnehmung 56d gebildeten, seitlich neben den Bedienmittelaufnahmebereichen 62d, 62d' gebildeten Teil des Funktionsmittelaufnahmebereichs 60d, sind Funktionsmittel 80d für das Bedienmittel 14d und Funktionsmittel 82d für ein zweites Bedienmittel 14d' angeordnet. In dem von der Ausnehmung 54d gebildeten Teil des Funktionsmittelaufnahmebereichs 60d sind von Drucksensoren 44d gebildete Funktionsmittel für das Bedienmittel 14d und von Drucksensoren 44d' gebildete Funktionsmittel für das Bedienmittel 14d' angeordnet, die auf einer gemeinsamen Trägerplatte 126d angeordnet sind. Die Drucksensoren 44d, 44d' sind entsprechend dem Ausführungsbeispiel in Figur 5 unter von materialverjüngten Bereichen der Bedienmittelträgereinheit 10d gebildeten Konturelementen 16d, 16d' angeordnet, die zur Weiterleitung von auf die Bedienmittel 14d, 14d' ausgeübten Druckkräften an die Drucksensoren 44d, 44d' vorgesehen sind.

Ferner umfasst die Kochfeldbedienvorrichtung aus Figur 7 dem Ausführungsbeispiel aus Figur 5 entsprechende Widerstandsreduzierungsmittel 46d, 48d und ein von einer Ausnehmung gebildetes Widerstandsreduzierungsmittel 50d für ein von einem Magneten gebildeten Funktionsmittel 86d.

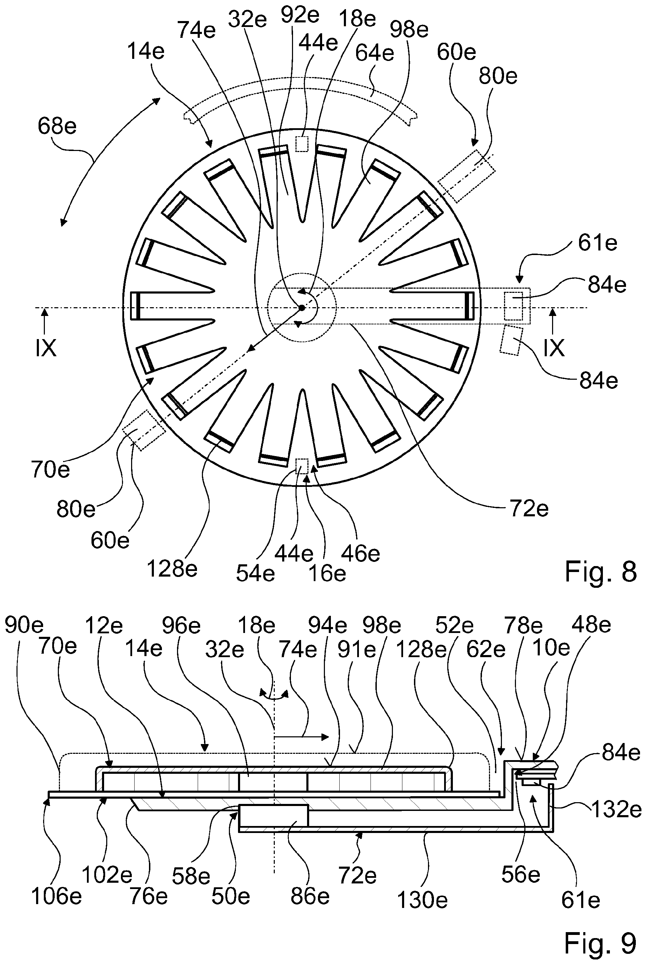

Figur 8 zeigt eine schematische Draufsicht auf eine Kochfeldbedienvorrichtung mit einem Bedienmittel 14e. Das Bedienmittel 14e umfasst ein Leitmittel 70e, welches entsprechend dem Leitmittel 70a, sich ausgehend von einem Bereich 92e in radialer Richtung 74e nach außen erstreckende Arme 98e aufweist. Die Arme 98e weisen in ihrem radial äußeren Bereich, in radialer Richtung 74e nach außen betrachtet, eine Abwinklung 128e von 90° in Richtung eines Bodendeckels 102e auf. Das Leitmittel 70e liegt an einem magnetischen Südpol eines Magneten 96e an, so dass sich an dessen Armen 98e ebenfalls ein magnetischer Südpol ausbildet (Fig. 9). Seitlich neben einem Bedienmittelaufnahmebereich 62e sind zwei von MR-Sensoren gebildete Funktionsmittel 84e in einem seitlich neben dem Bedienmittelaufnahmebereich 62e angeordneten Funktionsmittelaufnahmebereich 61 e angeordnet, die zur Erfassung einer Drehbewegung 18e des Bedienmittels 14e vorgesehen sind, und dabei mit den sich nach den Abwinklungen 128e nach unten in Richtung des Bodendeckels 102e erstreckenden Schenkeln der Arme 98e zusammenwirken.

Eine Bedienmittelträgereinheit 10e der Kochfeldbedienvorrichtung weist ein weiteres Leitmittel 72e auf. Das Leitmittel 72e wird von einem L-förmigen Blechteil mit einem ersten Schenkel 130e und einem zweiten Schenkel 132e gebildet. Das Leitmittel 72e liegt mit dem ersten Schenkel 130e an einer Unterseite eines von einem Permanentmagneten gebildeten Funktionsmittel 86e an und leitet mittels des ersten Schenkels 130e magnetische Feldlinien des Permanentmagneten in radialer Richtung 74e ausgehend von einer Drehachse 32e eines Funktionsfelds 12e bzw. des Bedienmittels 14e in einem funktionsgemäßen Zustand nach außen, und zwar in radialer Richtung 74e hinter eines der Funktionsmittel 84e. Der zweite Schenkel 132e verläuft, ausgehend von dem ersten Schenkel 130e parallel zur Drehachse 32e in Richtung einer Deckfläche 78e der Bedienmittelträgereinheit 10e, und zwar über einen Teil des Funktionsmittels 84e hinaus, so dass senkrecht zur Drehachse 32e verlaufende Ebenen, sowohl durch das Funktionsmittel 84e als auch durch den zweiten Schenkel 132e verlaufen und in diesen Ebenen vorteilhaft magnetische Feldlinien von den Schenkeln des Leitmittels 70e des Bedienmittels 14e durch das Funktionsmittel 84e zum zweiten Schenkel 132e des Leitmittels 72e geleitet werden können. Das Leitmittel 72e liegt an einem magnetischen Nordpol des Funktionsmittels 86e an, so dass sich am Schenkel 132e ebenfalls ein magnetischer Nordpol ausbildet und ein vorteilhaft gerichtetes Magnetfeld durch das Funktionsmittel 84e erreicht werden kann.

Entsprechend dem Ausführungsbeispiel in Figur 5, sind unter von materialverjüngten Bereichen der Bedienmittelträgereinheit 10e gebildeten Konturelementen 16e Drucksensoren 44e angeordnet. Die Konturelemente 16e sind dabei zur Weiterleitung von auf die Bedienmittel 14e ausgeübten Druckkräften an die Drucksensoren 44e vorgesehen.

Seitlich neben dem Bedienmittelaufnahmebereich 62e sind Funktionsmittelaufnahmebereiche 60e mit von Magneten gebildeten Funktionsmitteln 80e zur Erzeugung einer magnetischen Rastkraft bzw. einer Haltekraft in definierten Drehstellungen angeordnet.

Ferner umfasst die Kochfeldbedienvorrichtung aus Figur 8 dem Ausführungsbeispiel aus Figur 5 entsprechende Widerstandsreduzierungsmittel 46e, 48e und ein von einer Ausnehmung gebildetes Widerstandsreduzierungsmittel 50e für ein von einem Magneten gebildeten Funktionsmittel 86e.

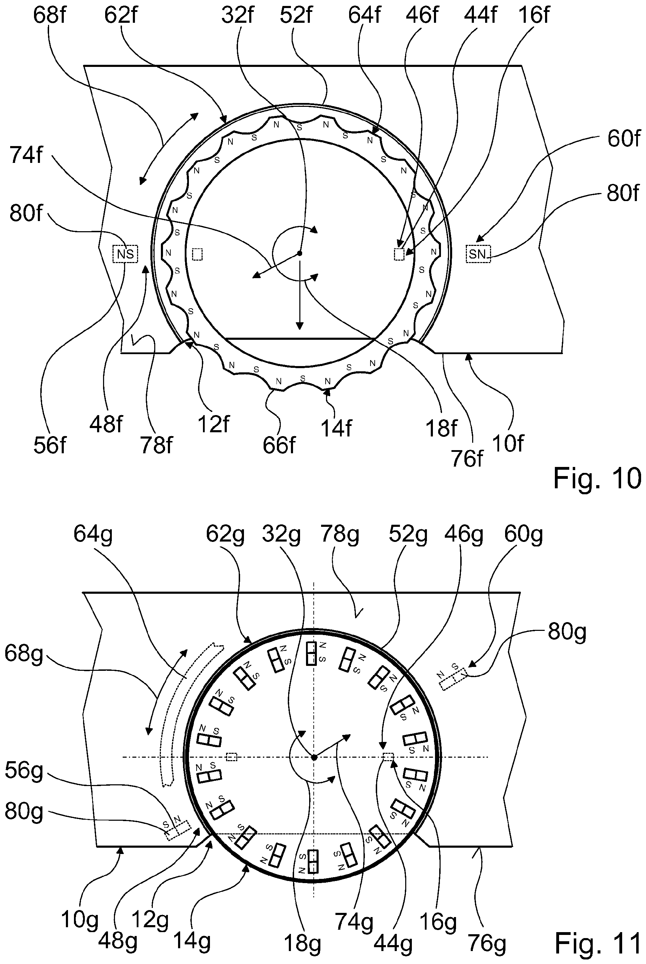

In Figur 10 ist ein Ausschnitt einer Kochfeldbedienvorrichtung mit einem Bedienmittel 14f dargestellt. Das Bedienmittel 14f umfasst ein Magnetmittel 64f, das sich ringförmig in Umfangsrichtung 68f eines Funktionsfelds 66f, mittels dessen das Bedienmittel 14f auf einem Funktionsfeld 12f einer Bedienmittelträgereinheit 10f im funktionsgemäßen Zustand aufliegt, bzw. in Umfangsrichtung 68f des kreisscheibenförmigen Bedienmittels 14f erstreckt. Das Magnetmittel 64f weist in Umfangsrichtung 68f gleichmäßig verteilt abwechselnd differierende Pole S, N auf, die in radialer Richtung 74f zu einer Drehachse 32f des Funktionsfelds 66f bzw. des Bedienmittels 14f unterschiedlich beabstandet sind. Das Magnetmittel 64f weist an seinem Außenumfang im Bereich der Pole S Einbuchtungen auf, wodurch in radialer Richtung 74f nach außen radial nach außen wirkende Wirkflächen der Pole S und der Pole N unterschiedlich zur Drehachse 32f beabstandet sind. Die radial nach außen wirkenden Wirkflächen der Pole S sind gekrümmt ausgebildet, und zwar konkav, und die radial nach außen wirkenden Wirkflächen der Pole N sind gerade ausgebildet. Die Pole S, N wirken mit in der Bedienmittelträgereinheit 10f bezogen auf die Drehachse 32f diametral gegenüberliegend angeordneten, von Stabmagneten gebildeten Funktionsmitteln 80f zusammen. Das Magnetmittel 64f und die Funktionsmittel 80f sind dazu vorgehen, magnetische Rastkräfte zu erzeugen, so dass das Bedienmittel 14f in definierten Drehstellungen einrastet bzw. gehalten wird. Bei den Ausführungsbeispielen in den Figuren 5 bis 9 und 11 sind entsprechend dem Ausführungsbeispiel in den Figuren 1 bis 4 in der Bedienmittelträgereinheit 10b - 10e; 10g ringförmige Magnetmittel 64b - 64e; 64g schematisch dargestellt, grundsätzlich wäre jedoch auch denkbar, dass bei den Ausführungsbeispielen dem Ausführungsbeispiel in Figur 10 entsprechende Bedienmittel eingesetzt werden.

Entsprechend dem Ausführungsbeispiel in Figur 5, sind unter von materialverjüngten Bereichen der Bedienmittelträgereinheit 10f gebildeten Konturelementen 16f Drucksensoren 44f angeordnet. Die Konturelemente 16f sind dabei zur Weiterleitung von auf die Bedienmittel 14f ausgeübten Druckkräften an die Drucksensoren 44f vorgesehen.

Seitlich neben einem Bedienmittelaufnahmebereich 62f sind Funktionsmittelaufnahmebereiche 60f mit von Magneten gebildeten Funktionsmitteln 80f zur Erzeugung einer magnetischen Rastkraft bzw. einer Haltekraft in definierten Drehstellungen angeordnet.

Ferner umfasst die Kochfeldbedienvorrichtung aus Figur 10 dem Ausführungsbeispiel aus Figur 5 entsprechende Widerstandsreduzierungsmittel 46f, 48f.

In Figur 11 ist ein Ausschnitt einer Kochfeldbedienvorrichtung mit einem Bedienmittel 14g dargestellt. Das Bedienmittel 14g weist gleichmäßig über den Umfang verteilte, mit ihrer Längserstreckung in radialer Richtung 74g ausgerichtete, Stabmagnete 134g auf, die in radialer Richtung 74g zu einer Drehachse 32g des Bedienmittels 14g in einem funktionsgemäßen Zustand differierende Pole S, N aufweisen. Die Stabmagnete 134g wirken mit in einer Bedienmittelträgereinheit 10g der Bedienvorrichtung angeordneten, ebenfalls von Stabmagneten gebildeten Funktionsmitteln 80g zusammen. Die Stabmagnete 134g und die Funktionsmittel 80g sind dazu vorgesehen, magnetische Rastkräfte zu erzeugen, so dass das Bedienmittel 14g in definierten Drehstellungen einrastet bzw. gehalten wird.

Entsprechend dem Ausführungsbeispiel in Figur 5, sind unter von materialverjüngten Bereichen der Bedienmittelträgereinheit 10g gebildeten Konturelementen 16g Drucksensoren 44g angeordnet. Die Konturelemente 16g sind dabei zur Weiterleitung von auf die Bedienmittel 14g ausgeübten Druckkräften an die Drucksensoren 44g vorgesehen.

Seitlich neben einem Bedienmittelaufnahmebereich 62g sind Funktionsmittelaufnahmebereiche 60g mit von Magneten gebildeten Funktionsmitteln 80g zur Erzeugung einer magnetischen Rastkraft bzw. einer Haltekraft in definierten Drehstellungen angeordnet.

Ferner umfasst die Kochfeldbedienvorrichtung aus Figur 11 dem Ausführungsbeispiel aus Figur 5 entsprechende Widerstandsreduzierungsmittel 46g, 48g.

**Bezugszeichen**

| | | | |
|---|---|---|---|
| 10 | Bedienmittelträgereinheit | 54 | Ausnehmung |
| 12 | Funktionsfeld | 56 | Ausnehmung |
| 14 | Bedienmittel | 58 | Ausnehmung |
| 16 | Konturelement | 60 | Funktionsmittelaufnahmebereich |
| 18 | Drehbewegung | | |
| 20 | Schrägfläche | 61 | Funktionsmittelaufnahmebereich |
| 22 | Ebene | | |
| 24 | Winkel | 62 | Bedienmittelaufnahmebereich |
| 26 | Fläche | 64 | Magnetmittel |
| 28 | Grundauflagefläche | 66 | Funktionsfeld |
| 30 | Abstand | 68 | Umfangsrichtung |
| 32 | Drehachse | 70 | Leitmittel |
| 34 | Erstreckung | 72 | Leitmittel |
| 36 | Sensoreinheit | 74 | Richtung |
| 38 | Auswerteeinheit | 76 | Seitenkontur |
| 40 | Betätigungsbereich | 78 | Deckfläche |
| 42 | Bereich | 79 | Kochfeldplatte |
| 43 | Erhöhung | 80 | Funktionsmittel |
| 44 | Drucksensor | 82 | Funktionsmittel |
| 45 | Kippauflagefläche | 84 | Funktionsmittel |
| 46 | Widerstandsreduzierungsmittel | 86 | Funktionsmittel |
| | | 88 | Stärke |
| 48 | Widerstandsreduzierungsmittel | 90 | Deckel |
| | | 91 | Deckfläche |
| 50 | Widerstandsreduzierungsmittel | 92 | Bereich |
| | | 94 | Anlagefläche |
| 52 | Ausnehmung | 96 | Magnet |
| 98 | Arm | | |
| 100 | Haltemittel | | |
| 102 | Bodendeckel | | |
| 104 | Rastmittel | | |
| 106 | Überstand | | |
| 108 | Kippachse | | |
| 110 | Wandstärke | | |
| 112 | Trägerplatte | | |
| 114 | Trägerplatte | | |
| 116 | Kippachse | | |
| 118 | Kippachse | | |
| 120 | Abwinklung | | |
| 122 | Abwinklung | | |
| 124 | Fläche | | |
| 126 | Trägerplatte | | |
| 128 | Abwinklung | | |
| 130 | Schenkel | | |
| 132 | Schenkel | | |
| 134 | Stabmagnet | | |
| S | Pol | | |
| N | Pol | | |

## Patentansprüche

1. Bedienvorrichtung eines Haushaltsgeräts, insbesondere Kochfeldbedienvorrichtung, mit einer Bedienmittelträgereinheit (10a-10g), die wenigstens ein Magnetmittel (64a - 64g) und wenigstens ein Funktionsfeld (12a -12g) aufweist, das zur lösbaren Kopplung mit wenigstens einem Bedienmittel (14a-14g) vorgesehen ist, wobei die Bedienmittelträgereinheit (10a-10g) zur Kopplung mit dem abnehmbaren Bedienmittel (14a - 14g) vorgesehen ist, und mit wenigstens dem abnehmbaren Bedienmittel (14a - 14g), das zur Kopplung mit dem Funktionsfeld (12a - 12g) vorgesehen ist, **dadurch gekennzeichnet, dass** das Bedienmittel (14a-14g) in einem funktionsmäßig gekoppelten Zustand mit dem Funktionsfeld (12a - 12g) über wenigstens eine Seitenkontur (76a; 76c; 76e; 76f; 76g) der Bedienmittelträgereinheit (10a - 10g) hinausragt, wobei das Magnetmittel (64a - 64g) sich zumindest ringsegmentförmig in Umfangsrichtung (68a - 68g) des Funktionsfelds (12a - 12e; 66f; 12g) erstreckt und das Magnetmittel (64a - 64g) bezogen auf eine Drehachse (32a - 32g) des Funktionsfelds (12a - 12e; 66f; 12g) in seinem inneren Bereich eine Ausnehmung aufweist-und in Umfangsrichtung (68a - 68g) eines sich um die Drehachse (32a - 32g) des Funktionsfelds (12a - 12e; 66f; 12g) erstreckenden Kreises eine Erstreckungskomponente aufweist, die zumindest doppelt so groß ist wie zumindest eine Erstreckungskomponente des Magnetmittels (64a - 64g) in radialer Richtung zur Drehachse (32a - 32g), wobei die Drehachse des Funktionsfelds (12a - 12e; 66f; 12g) eine mit der Drehachse des Bedienmittels (14a - 14g) in dessen funktionsgemäßen Zustand übereinstimmende Drehachse ist, um die das Bedienmittel (14a - 14g) zur Bedienung einer Einheit gedreht wird.

2. Bedienvorrichtung nach Anspruch 1,
**dadurch gekennzeichnet, dass**
das Magnetmittel (64a - 64g) in Umfangsrichtung (68a - 68g) differierende Pole (S, N) aufweist.

3. Bedienvorrichtung nach Anspruch 1 oder 2,
**dadurch gekennzeichnet, dass**
das Magnetmittel (64f) zumindest zwei Pole (S, N) aufweist, die in radialer Richtung (74f) zur Drehachse (32f) des Funktionsfelds (66f) unterschiedlich beabstandet sind.

4. Bedienvorrichtung nach einem der vorhergehenden Ansprüche, **dadurch gekennzeichnet, dass**
die Bedienmittelträgereinheit (10a - 10g), wenigstens ein Konturelement (16a - 16g) zur Realisierung wenigstens einer von einer Drehbewegung (18a - 18g) abweichenden Bedienfunktion aufweist.

5. Bedienvorrichtung nach Anspruch 4,
**dadurch gekennzeichnet, dass**
das Konturelement (16a; 16c) zur Realisierung einer Kippfunktion vorgesehen ist.

6. Bedienvorrichtung nach Anspruch 5,
**dadurch gekennzeichnet, dass**
das Konturelement (16a; 16c) eine Schrägfläche (20a; 20c) aufweist, die in einem funktionsgemäßen Zustand gegenüber einer horizontalen Ebene (22a) einen Winkel (24a) ungleich Null einschließt, und/oder eine gewölbte Fläche (26a) aufweist.

7. Bedienvorrichtung nach Anspruch 6,
**dadurch gekennzeichnet, dass**
das Funktionsfeld (12a; 12c) eine Grundauflagefläche (28a; 28c) aufweist, die in zumindest einem Bereich einen Abstand (30a; 30c) in radialer Richtung zu einer Drehachse (32a; 32c) des Funktionsfelds (12a; 12c) aufweist, der zumindest 30% einer maximalen Erstreckung (34a; 34c) des Funktionsfelds (12a; 12c) in radialer Richtung zur Drehachse (32a; 32c) aufweist.

8. Bedienvorrichtung nach einem der vorhergehenden Ansprüche, **gekennzeichnet durch**
wenigstens einen Drucksensor (44a; 44b; 44d - 44g).

9. Bedienvorrichtung nach einem der vorhergehenden Ansprüche
**dadurch gekennzeichnet, dass**
die Bedienmittelträgereinheit (10a - 10g) wenigstens ein Widerstandsreduzierungsmittel (46a - 50a; 46b, 48b; 46c, 48c; 46d - 50d; 46e - 50e; 46f, 48f; 46g, 48g) aufweist, das zur Reduzierung eines Signalwiderstands und/oder eines Haltekraftwiderstands vorgesehen ist.

10. Bedienvorrichtung nach Anspruch 9,
**dadurch gekennzeichnet, dass**
das Widerstandsreduzierungsmittel (46a - 50a; 46b, 48b; 46c, 48c; 46d - 50d; 46e - 50e; 46f, 48f; 46g, 48g) von wenigstens einer Ausnehmung (52a- 58a; 52b - 56b; 52c, 56c; 52d- 58d; 52e- 58e; 52f, 56f; 52g, 56g) gebildet ist.

11. Bedienvorrichtung nach einem der vorhergehenden Ansprüche
**dadurch gekennzeichnet, dass**
die Bedienmittelträgereinheit (10a - 10g) wenigstens einen Bedienmittelaufnahmebereich (62a - 62g) aufweist, in dem das Bedienmittel (14a - 14g) in einem funktionsgemäßen Zustand angeordnet ist, und wenigstens einen Funktionsmittelaufnahmebereich (60a - 60d; 60e, 61 e; 60f; 60g) aufweist, der seitlich neben dem Bedienmittelaufnahmebereich (62a - 62g) angeordnet ist.

12. Bedienvorrichtung nach einem der vorhergehenden Ansprüche,
**gekennzeichnet durch**
wenigstens ein magnetisierbares Leitmittel (70a; 70d; 70e, 72e), das in einem funktionsgemäßen Zustand zur Weiterleitung magnetischer Feldlinien in radialer Richtung (74a; 74d; 74e) zu einer Drehachse (32a; 32d; 32e) des Funktionsfelds (12e) und/oder des Bedienmittels (14a; 14d; 14e) vorgesehen ist.

13. Bedienvorrichtung nach einem der vorhergehenden Ansprüche,
**dadurch gekennzeichnet, dass**
die Bedienmittelträgereinheit (10a - 10g) zumindest teilweise von einer Bedienblende gebildet ist.

14. Bedienvorrichtung nach einem der vorhergehenden Ansprüche,
**dadurch gekennzeichnet, dass**
das abnehmbare Bedienmittel (14a - 14g) in einem funktionsmäßig gekoppelten Zustand mit dem Funktionsfeld (12a - 12g) über wenigstens eine Deckfläche (78a - 78g) der Bedienmittelträgereinheit (10a - 10g) hinausragt.

15. Bedienvorrichtung nach einem der vorhergehenden Ansprüche,
**dadurch gekennzeichnet, dass**
das Funktionsfeld (12c) zur Bedienung von zumindest zwei Kochstellen vorgesehen ist.

## Claims

1. Control device for a domestic appliance, in particular a hob control device, having a control means support unit (10a-10g) that has at least one magnet means (64a-64g) and at least one function field (12a-12g), which is provided for releasable coupling with at least one control means (14a-14g), wherein the control means support unit (10a-10g) is provided for coupling with the removable control means (14a-14g), and having at least the removable control means (14a-14g) provided for coupling with the function field (12a-12g), **characterised in that** the control means (14a-14g) protrudes, in a functionally coupled state with the function field (12a-12g), over at least one lateral contour (76a; 76c; 76e; 76f; 76g) of the control means support unit (10a-10g), wherein the magnet means (64a-64g) extends at least in the shape of an annular segment in the circumferential direction (68a-68g) of the function field (12a-12e; 66f; 12g) and the magnet means (64a-64g) has a recess in its inner region in relation to an axis of rotation (32a-32g) of the function field (12a-12e; 66f; 12g) and in the circumferential direction (68a-68g) of a circle extending about the axis of rotation (32a-32g) of the function field (12a-12e; 66f; 12g) has an extension component, which is at least twice as large as at least one extension component of the magnet means (64a-64g) in the direction radial to the axis of rotation (32a-32g), wherein the axis of rotation of the function field (12a-12e; 66f; 12g) is an axis of rotation corresponding to the axis of rotation of the control means (14a-14g) in its functional state and about which the control means (14a-14g) is rotated for control of a unit.

2. Control device according to claim 1,
**characterised in that**
the magnet means (64a-64g) has differing poles (S, N) in the circumferential direction (68a-68g).

3. Control device according to claim 1 or 2,
**characterised in that**
the magnet means (64f) has at least two poles (S, N) which are spaced differently in the radial direction (74f) to the axis of rotation (32f) of the function field (66f).

4. Control device according to one of the preceding claims,
**characterised in that**
the control means support unit (10a-10g) has at least one contour element (16a-16g) for implementing at least one control function differing from a rotary movement (18a-18g).

5. Control device according to claim 4,
**characterised in that**
the contour element (16a; 16c) is provided for implementing a tilting function.

6. Control device according to claim 5,
**characterised in that**
the contour element (16a; 16c) has an inclined surface (20a; 20c), which in a functional state forms an angle (24a) not equal to zero relative to a horizontal plane (22a), and/or has a curved surface (26a).

7. Control device according to claim 6,
**characterised in that**
the function field (12a; 12c) has a base support surface (28a; 28c), which in at least one region has a spacing (30a; 30c) in the direction radial to an axis of rotation (32a; 32c) of the function field (12a; 12c) which comprises at least 30% of a maximum extension (34a; 34c) of the function field (12a; 12c) in the direction radial to the axis of rotation (32a; 32c).

8. Control device according to one of the preceding claims,
**characterised by**
at least one pressure sensor (44a; 44b; 44d-44g).

9. Control device according to one of the preceding claims,
**characterised in that**
the control means support unit (10a-10g) has at least one resistance-reducing means (46a-50a; 46b, 48b; 46c, 48c; 46d-50d, 46e-50e; 46f, 48f; 46g, 48g) which is provided for reducing a signal resistance and/or a retention force resistance.

10. Control device according to claim 9,
**characterised in that**
the resistance-reducing means (46a-50a; 46b, 48b; 46c, 48c; 46d-50d, 46e-50e; 46f, 48f; 46g, 48g) is formed by at least one recess (52a-58a; 52b-56b, 52c, 56c, 52d-58d; 52e-58e; 52f, 56f; 52g, 56g).

11. Control device according to one of the preceding claims,
**characterised in that**
the control means support unit (10a-10g) has at least one control means receiving region (62a-62g), in which the control means (14a-14g) is arranged in a functional state, and has at least one function means receiving region (60a-60d; 60e, 61 e; 60f; 60g) which is arranged laterally adjacent to the control means receiving region (62a-62g).

12. Control device according to one of the preceding claims,
**characterised by**
at least one magnetisable conducting means (70a; 70d, 70e, 72e), which in a functional state is provided for onward transmission of magnetic field lines in the direction (74a; 74d; 74e) radial to an axis of rotation (32a; 32d; 32e) of the function field (12e) and/or of the control means (14a; 14d; 14e).

13. Control device according to one of the preceding claims,
**characterised in that**
the control means support unit (10a-10g) is at least partially formed by a front panel.

14. Control device according to one of the preceding claims,
**characterised in that**
the removable control means (14a-14g) protrudes, in a functionally coupled state with the function field (12a-12g), over at least one top surface (78a-78g) of the control means support unit (10a-10g).

15. Control device according to one of the preceding claims,
**characterised in that**
the function field (12c) is provided for control of at least two cooking zones.

## Revendications

1. Dispositif de commande d'un appareil ménager, notamment dispositif de commande de plaques de cuisson, comprenant une unité de support de moyens de commande (10a - 10g) qui présente au moins un moyen magnétique (64a - 64g) et au moins un champ de fonction (12a - 12g) qui est ménagé pour le couplage amovible à au moins un moyen de commande (14a - 14g), l'unité de support de moyens de commande (10a - 10g) étant ménagée pour le couplage au moyen de commande amovible (14a - 14g) et à au moins le moyen de commande amovible (14a - 14g) qui est ménagé pour le couplage au champ de fonction (12a- 12g), **caractérisé en ce que** le moyen de commande (14a - 14g), dans un état, conformément au fonctionnement, couplé au champ de fonction (12a - 12g) fait saillie au-delà d'au moins un contour latéral (76a ; 76c ; 76e ; 76f ; 76g) de l'unité de support de moyens de commande (10a - 10g), le moyen magnétique (64a - 64g) s'étendant, au moins en forme de segment annulaire, dans le sens circonférentiel (68a - 68g) du champ de fonction (12a -12e ; 66f ; 12g) et le moyen magnétique (64a - 64g), par rapport à un axe de rotation (32a - 32g) du champ de fonction (12a - 12e ; 66f ; 12g), présentant dans sa zone intérieure un évidement et, dans le sens circonférentiel (68a - 68g) d'un cercle s'étendant autour de l'axe de rotation (32a - 32g) du champ de fonction (12a - 12e ; 66f ; 12g), présentant une composante d'étendue qui est au moins le double d'au moins une composante d'étendue du moyen magnétique (64a - 64g) en direction radiale par rapport à l'axe de rotation (32a - 32g), l'axe de rotation du champ de fonction (12a - 12e ; 66f ; 12g) étant un axe de rotation coïncidant avec l'axe de rotation du moyen de commande (14a - 14g) dans l'état conforme au fonctionnement de ce dernier, autour duquel le moyen de commande (14a - 14g) est tourné pour la commande d'une unité.

2. Dispositif de commande selon la revendication 1,
**caractérisé en ce que**
le moyen magnétique (64a - 64 g) présente dans le sens circonférentiel (68a - 68g) des pôles (S, N) variant.

3. Dispositif de commande selon la revendication 1 ou 2,
**caractérisé en ce que**
le moyen magnétique (64f) présente au moins deux pôles (S, N) qui sont différemment distancés en direction radiale (74f) par rapport à l'axe de rotation (32f) du champ de fonction (66f).

4. Dispositif de commande selon l'une quelconque des revendications précédentes,
**caractérisé en ce que**
l'unité de support de moyens de commande (10a - 10g) présente au moins un élément à contour (16a- 16g) pour la réalisation d'au moins une fonction de commande différente d'un mouvement de rotation (18a - 18g).

5. Dispositif de commande selon la revendication 4,
**caractérisé en ce que**
l'élément à contour (16a; 16c) est ménagé pour la réalisation d'une fonction à bascule.

6. Dispositif de commande selon la revendication 5,
**caractérisé en ce que**
l'élément à contour (16a; 16c) présente une surface oblique (20a ; 20c) qui, dans un état conforme au fonctionnement, comprend un angle (24a) différent de zéro par rapport à un plan horizontal (22a), et/ou présente une surface bombée (26a).

7. Dispositif de commande selon la revendication 6,
**caractérisé en ce que**
le champ de fonction (12a, 12c) présente une surface de contact de base (28a ; 28c) qui, dans au moins une partie, présente un écart (30a ; 30c) en direction radiale par rapport à un axe de rotation (32a, 32c) du champ de fonction (12a ; 12c), lequel écart présente au moins 30% d'une étendue maximale (34a ; 34c) du champ de fonction (12a ; 12c) en direction radiale par rapport à l'axe de rotation (32a ; 32c).

8. Dispositif de commande selon l'une quelconque des revendications précédentes,
**caractérisé par**
au moins un capteur de pression (44a ; 44b ; 44d - 44g).

9. Dispositif de commande selon l'une quelconque des revendications précédentes,
**caractérisé en ce que**
l'unité de support de moyens de commande (10a - 10g) présente au moins un moyen de réduction de résistance (46a - 50a ; 46b ; 48b ; 46c, 48c ; 46d - 50d ; 46e - 50e ; 46f, 48f, 46g, 48g) qui est ménagé pour réduire une résistance de signal et/ou une résistance de force de maintien.

10. Dispositif de commande selon la revendication 9,
**caractérisé en ce que**
le moyen de réduction de résistance (46a - 50a ; 46b ; 48b ; 46c, 48c ; 46d - 50d ; 46e - 50e ; 46f, 48f, 46g, 48g) est formé par au moins un évidement (52a - 58a ; 52b - 56b ; 52c, 56c ; 52d - 58d ; 52e - 58e ; 52f, 56f ; 52g, 56g).

11. Dispositif de commande selon l'une quelconque des revendications précédentes,
**caractérisé en ce que**
l'unité de support de moyens de commande (10a - 10g) présente au moins une zone de logement de moyen de commande (62a - 62g) dans laquelle le moyen de commande (14a - 14g) est disposé dans un état conforme au fonctionnement, et présente au moins une zone de logement de moyen de fonctionnement (60a - 60d ; 60e, 61 e; 60f ; 60g) qui est disposée latéralement à côté de la zone de logement de moyen de commande (62a - 62g).

12. Dispositif de commande selon l'une quelconque des revendications précédentes,
**caractérisé par**
au moins un moyen de guidage (70a ; 70d ; 70e, 72e) magnétisable qui, dans un état conforme au fonctionnement, est ménagé pour transmettre des lignes de champ magnétiques en direction radiale (74a ; 74d ; 74e) par rapport à un axe de rotation (32a ; 32d ; 32e) du champ de fonction (12e) et/ou du moyen de commande (14a ; 14d ; 14e).

13. Dispositif de commande selon l'une quelconque des revendications précédentes,
**caractérisé en ce que**
l'unité de support de moyens de commande (10a - 10g) est formée au moins en partie par un bandeau de commande.

14. Dispositif de commande selon l'une quelconque des revendications précédentes,
**caractérisé en ce que**
le moyen de commande (14a - 14g) amovible, dans un état conformément au fonctionnement couplé au champ de fonction (12a - 12g), fait saillie au moins au-delà d'une surface de recouvrement (78a - 78g) de l'unité de support de moyens de commande (10a - 10g).

15. Dispositif de commande selon l'une quelconque des revendications précédentes,
**caractérisé en ce que**
le champ de fonction (12c) est ménagé pour la commande d'au moins deux plaques de cuisson.
